# FASCICULE DE BREVET EUROPEEN

(11) **EP 3 158 112 B1**
(45) Date de publication et mention de la délivrance du brevet: **06.03.2019**
(21) Numéro de dépôt: 15732601.8
(22) Date de dépôt: 23.06.2015
(51) Int. Cl.: C30B 29/04, C30B 25/00, C30B 25/04, C30B 25/18

(54) **PROCEDE DE FORMATION D'UN MONOCRISTAL DE DIAMANT A PARTIR D'UN SUBSTRAT MONOCRISTALLIN DE DIAMANT**
VERFAHREN ZUR HERSTELLUNG EINES EINKRISTALLDIAMANTEN EINES MATERIALS AUS EINEM EINKRISTALLINDIAMANTEN SUBSTRAT
METHOD FOR FORMING A DIAMOND MONOCRYSTAL FROM A DIAMOND MONOCRYSTALLINE SUBSTRATE

(30) Priorité: 23.06.2014 FR 1455773
(43) Date de publication de la demande: 26.04.2017
(73) Titulaire: Univ Paris XIII Paris-Nord Villetaneuse, 93430 Villetaneuse (FR); Centre National de la Recherche Scientifique (CNRS), 75016 Paris (FR)
(72) Inventeur: GICQUEL PRADEL, Alix, 75016 Paris (FR); MEHEDI, Hasan-al, Bogra 5800 (BD); MILLE, Vianney, 95170 Deuil La Barre (FR); ACHARD, Jocelyn, 95120 Ermont (FR); BRINZA, Ovidiu, 95170 Deuil La Barre (FR); NAAMOUN, Mehdi, 2000 Neuchâtel (CH)
(74) Mandataire: Regimbeau
(86) Numéro de dépôt international: PCT/EP2015/064136
(87) Numéro de publication internationale: WO 2015/197632

(56) Documents cités:
- EP-A2- 1 551 056
- JP-A- 2001 185 496
- US-A- 4 557 794
- US-A1- 2003 203 531
- US-A1- 2006 266 279
- US-A1- 2010 181 576
- US-B1- 6 500 257

## Description

### DOMAINE DE L'INVENTION

L'invention concerne un procédé de formation d'un monocristal de matériau à partir d'un substrat monocristallin.

### ETAT DE LA TECHNIQUE

Le développement de monocristaux de matériaux de très haute pureté et de très haute qualité cristalline connait depuis plusieurs années un intérêt grandissant.

En effet, ces monocristaux sont utilisés pour la fabrication de composants électroniques de puissance, de détecteurs de rayonnements de fortes énergies, de monochromateurs pour les rayonnements X synchrotron, de dispositifs optoélectroniques, optomécaniques, de dispositifs photoniques et de dispositifs électroniques performants.

Cependant, ces monocristaux peuvent présenter des impuretés et des dislocations qui limitent les performances des composants obtenus.

On distingue les dislocations de surface et les dislocations de coeur. Les dislocations de coeur sont des défauts cristallins étendus correspondant à des discontinuités dans l'organisation de la structure cristalline au sein du matériau monocristallin. Ces dislocations se comportent comme des pièges, des centres recombinants ou des chemins de conduction parasites pour les porteurs de charges, ce qui a pour conséquence d'abaisser les champs de claquage du matériau.

Une densité de dislocation de coeur est définie comme un rapport d'une longueur totale de dislocations (en mètre) sur un volume de cristal (en mètre cube). Les monocristaux présentent des densités de dislocations qui varient typiquement entre 10³ et 10¹² cm⁻². Plus la densité de dislocations est réduite, meilleures sont les qualités cristallines et les propriétés électriques et électroniques du monocristal.

On connait des techniques d'élaboration de monocristaux de diamant par haute pression / haute température (HPHT) permettant d'obtenir des monocristaux présentant de faibles densités de dislocations. Cependant, un inconvénient de ces techniques est qu'elles ne permettent pas de contrôler aisément la pureté des monocristaux obtenus, en raison de l'environnement de croissance qui est généralement constitué d'un bain de métal liquide sous pression. La pureté des monocristaux obtenus par ces procédés est donc généralement médiocre et incompatible avec les applications envisagées.

Contrairement aux techniques d'élaboration HPHT, les techniques de dépôt chimique en phase vapeur (CVD) permettent un bon contrôle du taux d'impuretés dans les monocristaux obtenus. Cependant, la qualité d'un monocristal obtenu par dépôt chimique en phase vapeur est dépendante de la qualité du substrat utilisé comme germe. En effet, le substrat peut contenir des dislocations de coeur qui se propagent dans le monocristal lors de sa croissance.

L'utilisation de substrats de très haute qualité, ne contenant pratiquement pas de dislocations, pourrait permettre de produire des monocristaux de très haute qualité. Cependant, de tels substrats sont rares et coûteux.

Le document WO2014045220 décrit une solution pour réduire les dislocations de coeur d'un monocristal. Cette solution repose sur un traitement de surface comprenant un processus de gravure du monocristal, le dépôt de nanoparticules métalliques dans les zones de défauts de la surface de monocristal et une reprise de croissance épitaxiale du monocristal. Un tel procédé permet de réduire la densité de dislocations mais pourrait conduire à la présence de nanoparticules métalliques dans le monocristal qui subira la croissance homoépitaxiale.

Une autre solution pour réduire les dislocations de coeur dans les monocristaux obtenus par CVD est l'utilisation de techniques mettant en oeuvre des étapes de surcroissance latérale (Epitaxial Lateral Overgrowth ou ELOG). Cette solution est par exemple décrite dans la publication "Metal organic vapour phase epitaxy of GaN and lateral overgrowth", Gibart, Pierre; Reports on Progress in Physics, Volume 67, Number 5, May 2004, pp. 667-715(49). JP2001185496A, US4557794A et US2006/0266279A1 divulguent des procédés pour l'obtention de monocristaux de diamant à partir de substrat utilisant la méthode ELOG.

US2003/0203531 A1, EP1551056A2 et US2010/0181576A1 divulguent des procédés pour l'obtention de mono-couche cristalline ayant une réduction de défaut utilisant la méthode ELOG.

Le principe de ces deux techniques est de bloquer la propagation des dislocations lors de la croissance de la couche de monocristal par le dépôt d'une couche d'un autre matériau sur certaines parties du cristal. La présence de ce dépôt oblige le matériau d'intérêt à effectuer une croissance latérale (c'est-à-dire une croissance selon la direction parallèle à la surface du substrat) au-dessus de cet autre matériau en l'encapsulant. Comme les dislocations ne peuvent se propager que selon une direction normale à la surface du substrat, la mise en oeuvre d'une croissance épitaxiale latérale permet de bloquer la propagation des dislocations. Ces techniques permettent la formation d'un cristal comprenant typiquement des densités de dislocations de l'ordre de 10⁵ cm⁻².

Il existe donc un besoin pour des procédés de traitement de monocristaux conduisant à l'obtention de monocristaux de matériaux de très haute qualité cristalline (densité de dislocations < 10³ cm⁻²) tout en maintenant une haute pureté du matériau.

### RESUME DE L'INVENTION

Un but de l'invention est de proposer un procédé permettant de former par CVD un monocristal de matériau présentant une très faible densité de dislocations de coeur, même à partir d'un substrat présentant une forte densité de dislocations.

Ce but est atteint dans le cadre de la présente invention grâce à un procédé de formation d'un monocristal de matériau à partir d'un substrat monocristallin ayant une surface présentant une alternance de creux et d'élévations, comprenant des étapes de :
a) former une couche de monocristal par croissance homoépitaxiale latérale entre les élévations,
b) détecter des zones de défauts dans la couche de monocristal par gravure de la couche de monocristal,
c) former un masque sur la couche de monocristal entre les zones de défauts détectées,
d) graver la couche de monocristal munie du masque, de manière à former des creux dans les zones de défauts et des élévations hors des zones de défauts,
e) répéter l'étape a).

Grâce à l'utilisation d'un masque à l'étape c), le procédé proposé conduit à la formation systématique de creux et d'élévations, ce qui permet en répétant l'étape a) de traiter toute la surface de la couche de monocristal.

De plus, l'étape b) préalable permet d'ajuster le masque en fonction des zones de défauts apparaissant dans la couche de monocristal, ce qui améliore l'efficacité du procédé.

De cette manière, le procédé proposé conduit à l'obtention d'un monocristal de matériau présentant très peu de défauts cristallins, sans nécessiter un substrat de départ très coûteux.

Le procédé peut en outre présenter les caractéristiques suivantes :
- la couche de monocristal formée lors de l'étape a) ne recouvre pas les élévations,
- le masque formé à l'étape c) présente des ouvertures agencées de sorte que les zones de défauts sont exposées lors de la gravure réalisée à l'étape d),
- le masque formé à l'étape c) recouvre une partie de la couche de monocristal ayant été formée entre les élévations à l'étape a),
- le masque formé à l'étape c) présente un motif ayant un angle de désorientation par rotation horizontale par rapport à un motif formé par l'alternance de creux et d'élévations,
- le procédé comprend des étapes préalables à l'étape a) de :
   f) former un masque sur la surface du substrat, et
   g) graver le substrat muni du masque pour former l'alternance de creux et d'élévations,
- le masque formé à l'étape f) est conservé lors de la formation de la couche de monocristal à l'étape a), de manière à bloquer une croissance normale de la couche de monocristal,
- le procédé comprend une étape de :
   h) éliminer le masque formé à l'étape f) avant de former la couche de monocristal lors de l'étape a),
- le procédé comprend une étape préalable à l'étape f) de :
   i) graver la surface du substrat de manière à éliminer une couche écrouie du substrat,
- le matériau est du diamant,
- les étapes b) à e) sont répétées jusqu'à l'obtention d'une densité de défauts dans la couche de monocristal, inférieure ou égale à un seuil prédéterminé,
- les étapes b) à e) sont répétées entre une et vingt fois, de préférence entre une et quatre fois.

Le monocristal obtenu par le procédé qui précède peut ensuite être utilisé comme germe pour produire des monocristaux de haute qualité, qui eux-mêmes pourront servir de germe pour produire d'autres monocristaux de haute qualité.

Ainsi, l'invention concerne également un procédé de fabrication d'un monocristal comprenant une étape de :
j) former un premier monocristal par croissance homoépitaxiale normale à partir d'un monocristal de matériau obtenu par le procédé tel que défini précédemment.

L'invention concerne également un procédé de fabrication d'un monocristal, comprenant en outre des étapes de :
k) former un deuxième monocristal par croissance homoépitaxiale normale à partir du premier monocristal,
l) répéter l'étape k) en utilisant le deuxième monocristal obtenu à l'étape k) précédente comme premier monocristal pour l'étape k) suivante.

Enfin, l'invention concerne également un procédé de fabrication d'un monocristal comprenant une étape de :
m) formation d'un monocristal par croissance homoépitaxiale normale et éventuellement latérale à partir d'un monocristal obtenu par le procédé de fabrication qui précède.

### PRESENTATION DES DESSINS

D'autres caractéristiques et avantages ressortiront encore de la description qui suit, laquelle est purement illustrative, et non limitative et doit être lue en regard des figures annexées parmi lesquelles :
- la figure 1 représente de manière schématique, sous forme de diagramme, les différentes étapes d'un procédé de formation d'un monocristal de diamant conforme à un mode de réalisation de l'invention, ainsi qu'un procédé de fabrication de monocristaux par croissance homoépitaxiale normale ou bien normale et latérale à partir d'un monocristal obtenu par le procédé qui précède,
- les figures 2 à 19 représentent de manière schématique les différentes étapes de ces procédés,
- les figures 20A, 20B et 20C sont des images réalisées par un microscope électronique à balayage, montrant l'évolution des dislocations au cours des différentes étapes du procédé.

### DESCRIPTION DETAILLEE D'UN MODE DE REALISATION

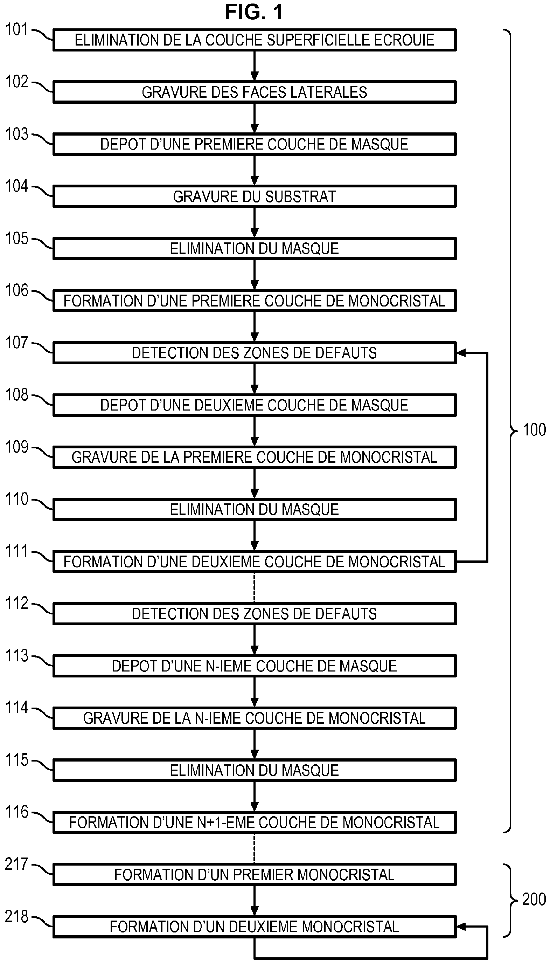

Sur la figure 1, le procédé 100 représenté est un procédé de formation d'un monocristal de diamant à partir d'un substrat « germe ».

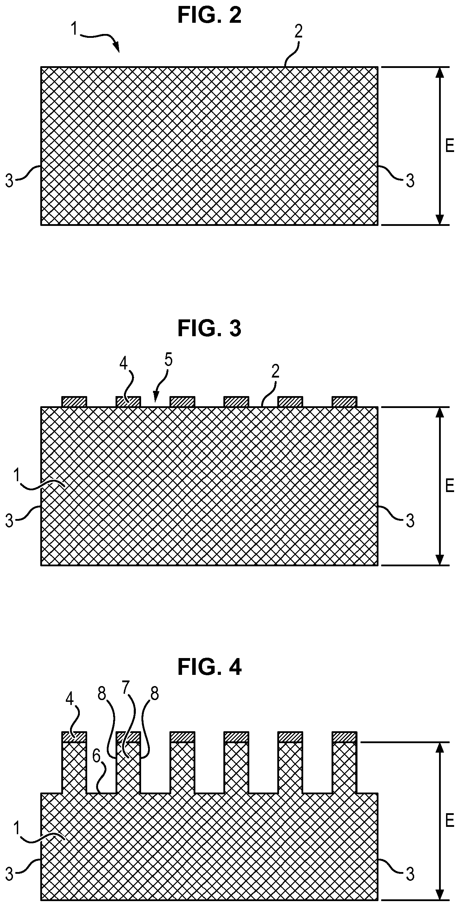

Le substrat « germe » 1 est représenté sur la figure 2. Il s'agit d'un substrat monocristallin en diamant, massif, présentant une face supérieure 2 et des faces latérales 3, et ayant une épaisseur E donnée. La face supérieure 2 présente initialement une surface plane. Comme la surface supérieure 2 est généralement polie, le substrat monocristallin comprend souvent une couche écrouie. Cette couche écrouie est superficielle et mesure généralement moins de 5µm.

Selon une première étape 101, la surface du substrat 1 est gravée par un procédé de gravure ionique réactive par plasma ICP-RIE afin d'éliminer une couche superficielle écrouie. D'autres types de plasmas, tels que hélicon, microonde en cavité ou ECR peuvent être utilisés lors de cette étape.

La première étape 101 du procédé permet de rendre lisse la surface du substrat 1 (c'est-à-dire présentant une rugosité typiquement inférieure à 30 nanomètres) et dépourvue de défauts ou dislocations de surface.

Dans le cas où la surface du substrat 1 présente déjà une rugosité faible et ne comprend pas de couche superficielle écrouie, la première étape 101 n'est pas nécessaire.

Selon une deuxième étape 102, les faces latérales 3 du substrat 1 sont gravées par plasma micro-onde de manière à relâcher les contraintes et à éliminer une partie des défauts de surface des faces latérales 3. Plusieurs types de gravures peuvent être utilisés, tels qu'une gravure sèche en plasma microonde et mélange H₂ - O₂, une gravure ionique réactive par plasma ICP-RIE avec différents gaz, hélion ou ECR, une gravure humide ou mécano-chimique. L'étape 102 peut être réalisée avant l'étape 101.

Selon une troisième étape 103, une première couche de masque 4 est déposée sur la surface du substrat 1 (figure 3).

Le masque 4 est formé en un matériau diélectrique qui peut être réalisé par lithographie optique mettant en oeuvre une résine photosensible positive ou négative. Plusieurs types de résine peuvent convenir selon leurs caractéristiques elles seront déposées directement sur le monocristal ou bien sur une couche intermédiaire telle que SiO₂ par exemple. Le masque 4 est révélé par des processus adaptés. Alternativement, le masque peut être réalisé par lithographie électronique.

Le masque 4 présente un motif répétitif incluant des ouvertures 5 disposées à intervalles réguliers. Toutefois, ce masque 4 pourrait présenter des ouvertures 5 disposées à intervalles irréguliers. De cette manière, la surface du substrat 1 est exposée à travers les ouvertures 5. La dimension d'une ouverture 5 est de préférence comprise entre 1 et 100 micromètres, et de façon plus préférée, entre 5 et 30 micromètres. Le pas entre deux ouvertures 5 successives est compris entre 1 et 100 micromètres, de préférence entre 2 et 20 micromètres.

Selon une quatrième étape 104, le substrat 1 est gravé à travers le masque 4 (Figure 4). La gravure du substrat 1 peut être réalisée par gravure anisotrope. La gravure anisotrope peut être réalisée par un procédé plasma de type Inductively Coupled Plasma Reactive-Ion Etching (ICP-RIE), Electron Cyclotron Resonance (ECR) ou par d'autres procédés plasmas. Le substrat 1 est gravé sur une épaisseur typiquement comprise entre 1 et 50 micromètres.

La quatrième étape 104 du procédé conduit à la formation d'une alternance périodique de creux 6 dans les zones exposées de la surface du substrat 1 (zones de la surface situées à l'endroit des ouvertures du masque 4) et d'élévations initiales 7 dans les zones masquées de la surface du substrat 1 (zones de la surface recouvertes par le masque 4) dans une épaisseur inférieure à l'épaisseur donnée E du substrat monocristallin 1 massif.

Les élévations initiales 7 peuvent présenter la forme de piliers, de plots, de mesas, de pointes, de pyramides ou de bandes nanométriques ou micrométriques. Chaque élévation initiale 7 présente des parois latérales 8 s'étendant selon une direction sensiblement perpendiculaire à la face supérieure 2 du substrat 1. Les parois latérales 8 des élévations initiales 7 délimitent les creux 6 formés dans le substrat 1 massif.

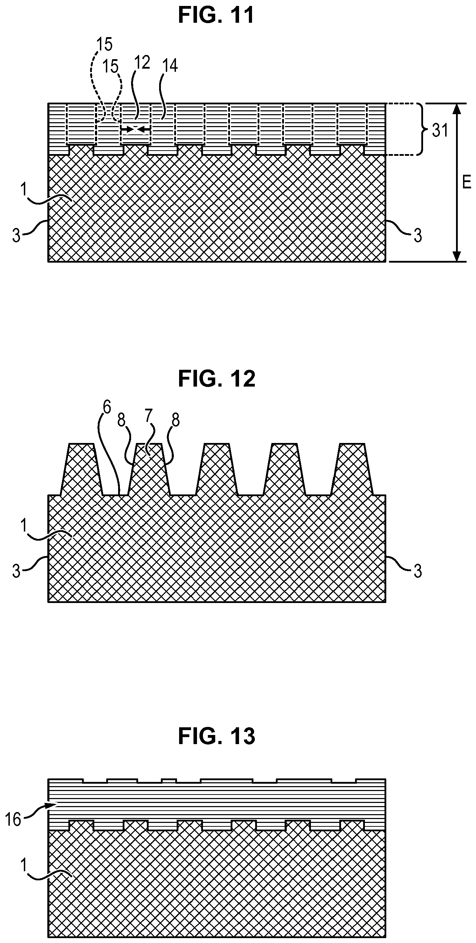

La figure 12 représente de manière schématique une variante de la quatrième étape 104, dans laquelle les élévations 7 initiales formées présentent des parois latérales 8 inclinées par rapport à une direction perpendiculaire à la face supérieure 2 du substrat 1 massif. L'inclinaison des parois est de préférence comprise entre 0 et 10 degrés.

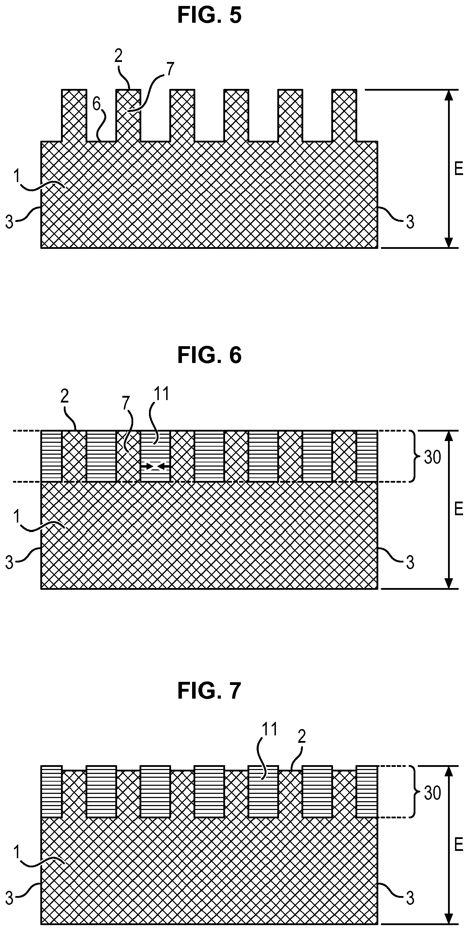

Selon une cinquième étape 105, le masque 4 est éliminé (figure 5). La réalisation de cette étape 105 n'est pas obligatoire. En effet, le masque 5 peut être conservé afin d'empêcher une croissance normale à partir des élévations initiales 7, lors de l'étape 106 suivante.

Les étapes 103 à 105 du procédé conduisent à l'obtention d'un substrat 1 dont la surface présente une alternance de creux et d'élévations. Le rapport d'aspect (rapport entre la hauteur des élévations 7 initiales et le pas entre deux creux 6 successifs) est de préférence compris entre 0,1 et 40.

Selon une sixième étape 106, une première croissance épitaxiale latérale par CVD est réalisée à partir des parois latérales 8 des élévations 7 initiales. La croissance est poursuivie jusqu'à coalescence du matériau entre les élévations initiales 7 pour former des parties 11 de couche de monocristal de haute qualité cristalline (figure 6).

En favorisant une croissance homoépitaxiale latérale des parties 11 (c'est-à-dire une croissance dont la direction de croissance est parallèle à la face supérieure 2 du substrat 1), vis-à-vis d'une croissance épitaxiale normale (c'est-à-dire une croissance dont la direction est perpendiculaire à la face supérieure 2 du substrat 1), la sixième étape 106 permet de bloquer les dislocations traversantes qui ne se propagent que dans la direction normale. Cette étape conduit par conséquent à la formation d'une première couche 30 de monocristal de diamant contenant les parties 11 de haute qualité cristalline (sans défaut traversant) entre les élévations initiales 7.

Selon une septième étape 107, la première couche 30 de monocristal est gravée.

Cette gravure est légère de manière uniquement à révéler des zones de défauts (Figure 7). La gravure est réalisée sur une épaisseur faible, comprise entre 0,1 et 2 micromètres, juste suffisante pour permettre la détection des zones de défauts. La gravure est par exemple une gravure sèche en plasma microonde constitué d'un mélange de gaz tel que H₂ - O₂.

Des zones de défauts apparaissent principalement sur les élévations 7 initiales, mais éventuellement également autour des élévations 7 initiales.

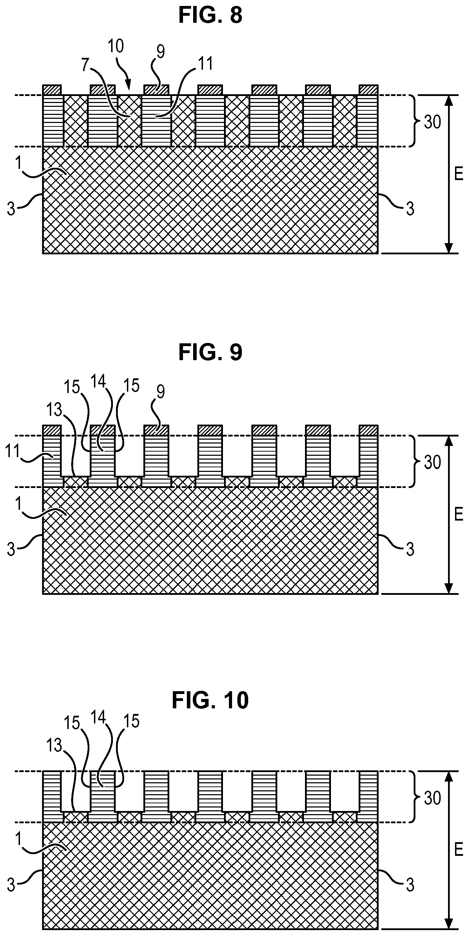

Selon une huitième étape 108, une deuxième couche de masque 9 est déposée sur la première couche 30 de monocristal (figure 8).

Le masque 9 présente un motif incluant des ouvertures 10 disposées à intervalles réguliers. Les ouvertures 10 sont au moins en partie voire avantageusement centrées sur les élévations 7 initiales du substrat 1 et englobent en outre les zones de défauts détectées autour de ces élévations initiales 7 lors de la septième étape 107 qui précède. Toutefois, dans le cas où le masque pourrait présenter des ouvertures 5 disposées à intervalles irréguliers, le masque 9 présente un motif incluant des ouvertures 10 disposées à intervalles irréguliers, et qui se situent au moins en partie voire centrées sur les élévations initiales 7.

Dans le cas où, pour une raison ou une autre, il reste des défauts qui ne sont pas situés au niveau des élévations initiales, on pourrait éventuellement choisir de dessiner un masque adapté qui aurait des ouvertures 10 disposées à intervalles irréguliers, alors que les ouvertures 5 peuvent être disposées régulièrement.

Autrement dit, la deuxième couche de masque 9 peut présenter un motif sensiblement complémentaire du motif de la première couche de masque 4, tout en ayant des ouvertures 10 suffisamment larges pour englober des zones de défauts situées autour des élévations 7 initiales. De façon préférée, le masque 9 présente un motif incluant des ouvertures 10 centrées sur les élévations initiales 7 et ayant une surface de 2 à 10 fois plus grande que la surface supérieure des élévations initiales 7.

De plus, la deuxième couche de masque 9 peut présenter un angle de désorientation par rotation horizontale par rapport à la première couche de masque 4. L'angle de désorientation est compris entre 0,1 et 90 degrés, de préférence entre 5 et 45 degrés. Cela permet notamment d'augmenter la vitesse de coalescence.

Selon une neuvième étape 109, la première couche de monocristal 30 (composée des élévations initiales 7 et des parties 11, voir figures 6 à 10), est gravée à travers le masque 9 (Figure 9), ce qui conduit à la gravure des élévations initiales 7 et de leur pourtour. La gravure de la première couche 30 de monocristal peut être réalisée par gravure anisotrope telle qu'une gravure par un procédé plasma de type Inductively Coupled Plasma Reactive-Ion Etching (ICP-RIE), Electron Cyclotron Resonance (ECR) ou par d'autres procédés plasmas.

La première couche de monocristal 30 est gravée sur une épaisseur égale ou inférieure ou supérieure, à l'épaisseur des parties 11.

La neuvième étape 109 du procédé conduit à la formation d'une alternance de creux 13 dans les zones exposées de la première couche de monocristal 30 (zones de la première couche situées à l'endroit des ouvertures 10 du masque) et de nouvelles élévations 14 dans les zones masquées de la première couche de monocristal (zones de la première couche recouvertes par le masque 9), dans une épaisseur inférieure à l'épaisseur donnée E du substrat monocristallin 1 et contenue dans l'épaisseur donnée E.

Ainsi, la majeure partie des zones de la première couche de monocristal 30 formées par les parties 11 qui ont cru latéralement et qui sont dépourvues de défauts restent en place et forment les nouvelles élévations 14 dans une épaisseur inférieure à l'épaisseur donnée E du substrat monocristallin 1 et contenue dans l'épaisseur donnée E. Ainsi, le procédé selon l'invention se passe dans la même épaisseur donnée E de substrat monocristallin (il ne s'agit pas d'un procédé ELOG) et consiste à remplacer les élévations initiales 7 dans l'étape a) du procédé par de nouvelles élévations 14 qui peuvent éventuellement être remplacées par d'autres nouvelles élévations et ainsi de suite, jusqu'à obtenir un diamant avec un taux de dislocations très faible.

A noter que les nouvelles élévations 14 ne sont pas nécessairement situées exactement à l'endroit où se situaient les creux 6.

Selon une dixième étape 110, le masque 9 est éliminé (figure 9). La réalisation de cette étape 110 n'est pas obligatoire mais elle est préférée. En effet, le masque 9 peut être conservé afin d'empêcher une croissance normale à partir des élévations, lors de l'étape 111 suivante.

Les étapes 108 à 110 du procédé conduisent à l'obtention d'une première couche 30 de monocristal présentant une alternance de creux 13 et de nouvelles élévations 14. Chaque nouvelle élévation 14 présente des parois latérales 15 s'étendant selon une direction sensiblement perpendiculaire à la face supérieure 2 du substrat 1. Les parois latérales 15 délimitent les creux 13 formés dans la première couche 30 de monocristal.

Le rapport d'aspect (rapport entre la hauteur des nouvelles élévations 14 et le pas entre deux creux 13 successifs) est de préférence compris entre 0,1 et 40.

Selon une onzième étape 111, une deuxième croissance homoépitaxiale latérale par CVD est réalisée à partir des parois latérales 15 des nouvelles élévations 14 dans une épaisseur donnée inférieure à l'épaisseur donnée E et contenue dans l'épaisseur donnée E. La croissance est poursuivie jusqu'à coalescence du matériau entre les nouvelles élévations 14 pour former des parties 12 de couche de monocristal de haute qualité cristalline (figure 11).

En favorisant une croissance homoépitaxiale latérale des parties 12 (c'est-à-dire une croissance dont la direction de croissance est parallèle à la face supérieure 2 du substrat 1), vis-à-vis d'une croissance homoépitaxiale normale (c'est-à-dire une croissance dont la direction est perpendiculaire à la face supérieure 2 du substrat 1), la onzième étape 111 permet de bloquer les dislocations traversantes qui se propagent dans la direction normale. Cette étape conduit par conséquent à la formation d'une deuxième couche 31 de monocristal de diamant contenant des parties 12 de haute qualité cristalline sans défaut traversant entre les nouvelles élévations 14 de haute qualité cristalline sans défaut traversant précédemment formées.

Les étapes 107 à 111 peuvent être répétées jusqu'à l'obtention d'une densité de défauts dans la couche de monocristal, inférieure ou égale à un seuil prédéterminé, par exemple égal à 10³ cm⁻². Les étapes 107 à 111 sont répétées de préférence entre une et quatre fois.

Le procédé proposé conduit ainsi à l'obtention d'une couche continue 16 de monocristal de diamant dépourvu de défaut traversant (ou du moins contenant bien moins de défauts traversants que le cristal germe).

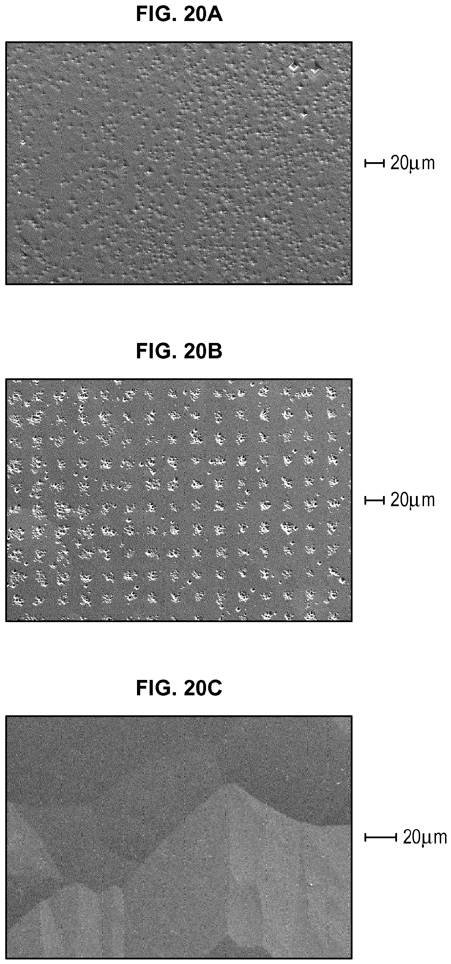

Les figures 20A à 20C montrent l'évolution des dislocations au cours des différentes étapes du procédé. Les dislocations sont rendues visibles par gravure légère et observation au microscope électronique à balayage.

Plus précisément, la figure 20A montre la surface du substrat 1, avant la mise en oeuvre du procédé, après gravure par plasma H₂- 3 % O₂. On observe des figures de gravure dispersées sur toute la surface du substrat, témoins de la présence de dislocations.

La figure 20B montre la première couche 30 de monocristal à l'issue de la septième étape 107, au cours de laquelle la première couche 30 a été gravée pendant 10 minutes par plasma H₂- 3 % O₂. On observe des figures de gravure alignées sur les élévations 7 initiales.

La figure 20C montre la deuxième couche 31 de monocristal à l'issue de la onzième étape 111, après gravure par plasma H₂- 3 % O₂ pendant 5 minutes. On observe quelques figures de gravure, témoins de la présence de quelques dislocations résiduelles dans la couche de monocristal 31.

Il est possible de prévoir des étapes supplémentaires entre les étapes 110 et 111, selon lesquelles la surface de la première couche 30 de monocristal est gravée par un procédé de gravure ionique réactive par plasma ICP-RIE afin d'éliminer une couche superficielle écrouie. Ces étapes supplémentaires seraient nécessaires dans le cas où un polissage serait réalisé sur la couche 30 de monocristal avec un angle de désorientation vertical par rapport à la face cristallographique exacte du matériau de la première couche 30 (par rapport à la face supérieure 2), compris de préférence entre 0,1 et 10 degrés. Ces étapes peuvent être mises en oeuvre pour favoriser la croissance latérale et conduire éventuellement au recouvrement par les zones de haute qualité cristalline sans défaut traversant 12 de monocristal des nouvelles élévations 14. Dans ce cas, le masque 9 est obligatoirement éliminé avant l'étape de polissage de la première couche 30.

Par ailleurs, les étapes finales suivantes peuvent être réalisées.

Selon une douzième étape 112 similaire à la septième étape 107, la n-ième couche de monocristal 16 est gravée légèrement de manière à révéler les toutes dernières zones de défauts dans la couche de monocristal (Figure 13).

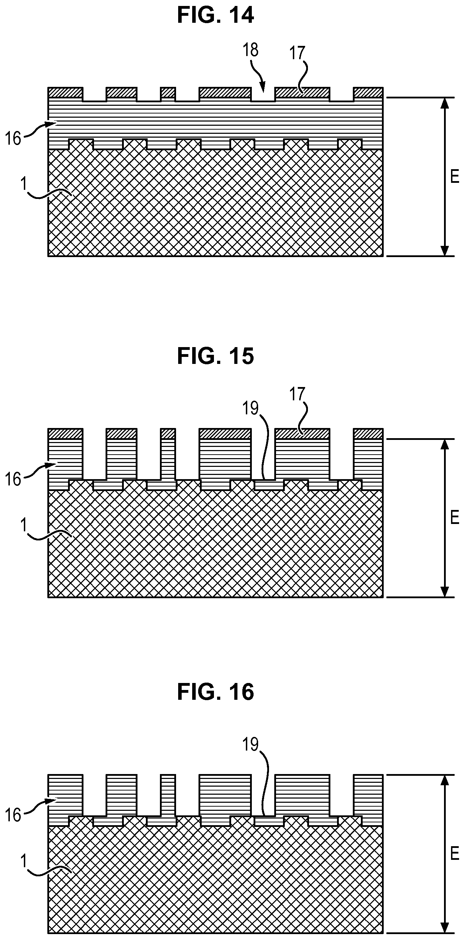

Selon une treizième étape 113, une dernière couche de masque 17 est déposée sur la n-ième couche de monocristal 16 (Figure 14). Le masque 17 inclut des ouvertures 18 disposées uniquement sur les zones de défauts détectées lors de la douzième étape 112 qui précède.

Selon une quatorzième étape 114, la n-ième couche de monocristal 16 est gravée uniquement dans les zones où subsistent les défauts révélés à l'étape 112 (Figure 15). Cette étape de gravure conduit à la formation de creux 19 dans la n-ième couche de monocristal 16 à l'endroit des zones de défauts initiales.

Selon une quinzième étape 115, le masque 17 est éliminé (Figure 16).

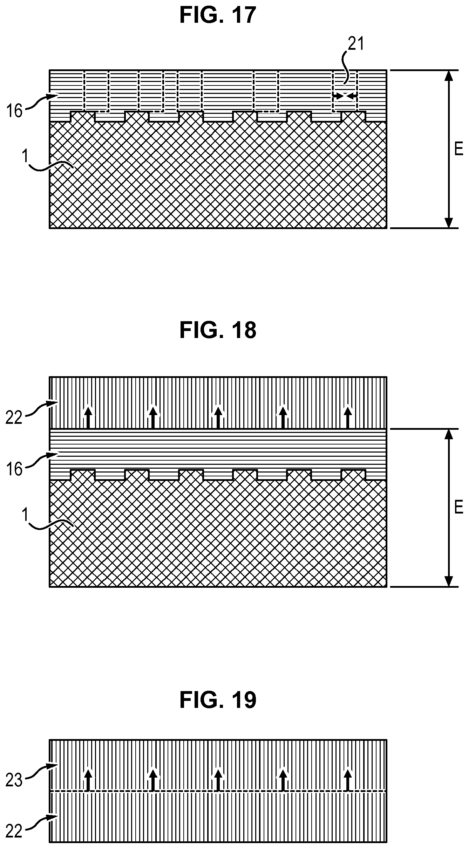

Selon une seizième étape 116, une n+1-ième couche 21 de monocristal de diamant est formée par croissance homoépitaxiale latérale à l'intérieur des creux 19 de la n-ième couche de monocristal 16 (Figure 17). La croissance est poursuivie jusqu'à coalescence du matériau de la n-ième couche 21.

Le procédé proposé permet de former un monocristal de diamant 16 présentant une très faible densité de dislocations, par exemple inférieure ou égale à 10³ cm⁻², de préférence inférieure ou égale à 10² cm⁻², de façon plus préférée, inférieure ou égale à 10 cm⁻², à partir d'un substrat 1 présentant une forte densité de dislocations, par exemple supérieure ou égale à 10⁵ cm⁻².

Sur la figure 1, le procédé 200 représenté est un procédé de fabrication de monocristaux de diamant utilisant le monocristal de diamant 16 comme germe.

Selon une dix-septième étape 217, un premier monocristal de diamant 22 est formé par croissance épitaxiale normale à partir du monocristal 16 obtenu par le procédé 100 (Figure 18). Notons que la croissance normale du monocristal 22 peut également être accompagnée d'une croissance latérale du cristal, ce qui aura l'avantage d'accroître sa surface.

La croissance homoépitaxiale normale peut être réalisée sur plusieurs centaines de micromètres, voire plusieurs millimètres. De préférence les cristaux produits ont une épaisseur supérieure à 4 mm.

De plus, chaque monocristal 22 obtenu peut être lui-même utilisé pour produire un nouveau monocristal 23, par croissance homoépitaxiale normale.

Le procédé de fabrication comprend une dix-huitième étape 218 selon laquelle un deuxième monocristal 23 est formé par croissance homoépitaxiale normale à partir d'un premier monocristal 22 (Figure 19).

La dix-huitième étape 218 peut être répétée en utilisant le deuxième monocristal obtenu comme premier monocristal.

Il faut noter que chaque croissance normale peut être éventuellement accompagnée d'une croissance latérale afin d'accroître la surface des monocristaux 22, 23 ... et ainsi de suite.

## Revendications

1. Procédé (100) de formation d'un monocristal de matériau de diamant à partir d'un substrat monocristallin (1) ayant une épaisseur donnée E et une surface présentant une alternance de creux (6) et d'élévations initiales (7), le procédé se déroulant dans la même épaisseur donnée E, sans surcroissance latérale épitaxiée ELOG, et comprenant des étapes de :
a) former des parties (11) par croissance homoépitaxiale latérale entre les élévations initiales (7) pour réaliser une couche de monocristal (30) ayant une épaisseur inférieure à l'épaisseur donnée E du substrat monocristallin (1) et contenue dans l'épaisseur donnée E, le substrat monocristallin (1) et la couche de monocristal (30) étant formés en un même matériau,
b) détecter des zones de défauts dans la couche de monocristal (30) par gravure de la couche de monocristal, qui apparaissent au moins en partie sur les élévations initiales (7),
c) former un masque (9) sur la couche (30) de monocristal entre les zones de défauts détectées, le masque (9) présentant un motif incluant des ouvertures (10) au niveau des zones de défauts,
d) graver dans une épaisseur inférieure à l'épaisseur donnée E de substrat monocristallin (1), la couche (30) de monocristal munie du masque (9) de manière à former des creux (13) dans les zones de défauts de la couche (30) situées à l'endroit des ouvertures (10), et des nouvelles élévations (14) hors des zones de défauts de la couche (30) dans les zones masquées de la couche de monocristal (30) recouvertes par le masque (9),
e) répéter une nouvelle étape a) entre les nouvelles élévations (14) par croissance homoépitaxiale latérale à partir des parois latérales (15) des nouvelles élévations (14) dans une épaisseur inférieure à l'épaisseur donnée E de substrat monocristallin et contenue dans l'épaisseur donnée E, pour former une couche de monocristal (31),
le masque (9) ayant été éliminé à la fin de l'étape (d) ou à la fin de l'étape (e).

2. Procédé selon la revendication 1, dans lequel à l'étape c), le masque (9) présente un motif incluant des ouvertures (10) situées au moins en partie sur les élévations initiales (7).

3. Procédé selon la revendication 1 ou 2, dans lequel à l'étape c), le masque (9) présente un motif incluant des ouvertures (10) centrées sur les élévations initiales (7).

4. Procédé selon l'une des revendications 1 à 3, dans lequel le masque (9) formé à l'étape c) présente un motif ayant un angle de désorientation par rotation horizontale par rapport au motif formé par l'alternance de creux (6) et d'élévations initiales (7).

5. Procédé selon l'une des revendications 1 à 4, comprenant des étapes préalables à l'étape a) de :
f) former un masque (4) sur la surface du substrat (1), et
g) graver le substrat (1) muni du masque (4) pour former l'alternance de creux (6) et d'élévations initiales (7) dans la surface du substrat (1).

6. Procédé selon la revendication 5, comprenant une étape préalable à l'étape f) de :
i) graver la surface du substrat (1) de manière à éliminer une couche écrouie du substrat et à obtenir une faible rugosité de surface, typiquement inférieure à 30 nm.

7. Procédé selon l'une des revendications 1 à 6, dans lequel on élimine le masque (9) formé à l'étape c) avant de former la couche de monocristal (31) lors de l'étape e), ou dans lequel on élimine le masque (4) formé à l'étape f) avant de former la couche de monocristal (30) lors de l'étape a).

8. Procédé selon l'une des revendications 1 à 7, dans lequel les étapes b) à e) sont répétées jusqu'à l'obtention d'une densité de défauts dans la couche de monocristal (30, 31), inférieure ou égale à un seuil prédéterminé.

9. Procédé selon l'une des revendications 1 à 8, dans lequel les étapes b) à e) sont répétées entre une et vingt fois, de préférence entre une et quatre fois.

10. Procédé (200) de fabrication d'un monocristal, comprenant une étape de :
j) former un premier monocristal (22) par croissance homoépitaxiale normale à partir d'un monocristal (16) de matériau obtenu par le procédé tel que défini par l'une des revendications 1 à 9.

11. Procédé (200) de fabrication d'un monocristal selon la revendication 10, comprenant en outre des étapes de :
k) former un deuxième monocristal (23) par croissance homoépitaxiale normale à partir du premier monocristal (22),
l) répéter l'étape k) en utilisant le deuxième monocristal obtenu à l'étape k) précédente comme premier monocristal pour l'étape l) suivante.

12. Procédé (200) de fabrication d'un monocristal selon l'une des revendications 10 à 11, dans lequel les étapes j) et/ou k) sont réalisées avec une croissance homoépitaxiale normale et latérale à partir du premier monocristal (22).

13. Procédé (200) de fabrication d'un monocristal comprenant une étape de :
m) former un monocristal (23) par croissance homoépitaxiale à partir d'un monocristal (22) obtenu par le procédé tel que défini par la revendication 10, 11 ou 12.

## Patentansprüche

1. Verfahren (100) zur Bildung eines Einkristalls aus Diamantmaterial ausgehend von einem Einkristallsubstrat (1) mit einer bestimmten Dicke E und einer Oberfläche, die eine Abwechslung aus Vertiefungen (6) und anfänglichen Erhebungen (7) aufweist, wobei das Verfahren in derselben bestimmten Dicke E ohne epitaxierte laterale Überwucherungen ELOG abläuft und die Schritte umfasst:
a) Bilden der Teile (11) per lateralem, homoepitaxialen Wachstum zwischen den anfänglichen Erhebungen (7) zum Realisieren einer Einkristallschicht (30) mit einer Dicke, die geringer ist als die bestimmte Dicke E des Einkristallsubstrats (1) und die in der bestimmten Dicke E inbegriffen ist, wobei das Einkristallsubstrat (1) und die Einkristallschicht (30) aus einem und demselben Material gebildet sind,
b) Detektieren der Mängelbereiche in der Einkristallschicht (30) per Gravur der Einkristallschicht, die wenigstens teilweise auf den anfänglichen Erhebungen (7) erscheinen,
c) Bilden einer Maske (9) auf der Einkristallschicht (30) zwischen den detektierten Mängeln, wobei die Maske (9) ein Muster aufweist, das Öffnungen (10) an den Mängelbereichen einschließt,
d) Gravieren der mit der Maske (9) versehenen Einkristallschicht (30) in einer geringeren Dicke als der bestimmten Dicke E des Einkristallsubstrats (1) derart, dass Vertiefungen (13) in den Mängelbereichen der Schicht (30), die an der Stelle der Öffnungen (10) angeordnet sind, und neue Erhebungen (14) außerhalb der Mängelbereiche der Schicht (30) in den maskierten Bereichen der Einkristallschicht (30), die von der Maske (9) abgedeckt sind, gebildet sind,
e) Wiederholen eines neuen Schritts a) zwischen den neuen Erhebungen (14) per lateralem homoepiaxialen Wachstum ausgehend von den lateralen Wänden (15) der neuen Erhebungen (14) in einer Dicke, die geringer ist als die bestimmte Dicke E des Einkristallsubstrats und in der bestimmten Dicke E inbegriffen ist, um eine Einkristallschicht (31) zu bilden,
wobei die Maske (9) am Ende des Schritts (d) oder am Ende des Schritts (e) eliminiert ist.

2. Verfahren gemäß Anspruch 1, bei dem die Maske (9) in Schritt c) ein Muster aufweist, das Öffnungen (10) einschließt, die wenigstens zum Teil auf den anfänglichen Erhebungen (7) angeordnet sind.

3. Verfahren gemäß Anspruch 1 oder 2, bei dem die Maske (9) in Schritt c) ein Muster aufweist, das Öffnungen (10) einschließt, die auf den anfänglichen Erhebungen (7) zentriert sind.

4. Verfahren gemäß einem der Ansprüche 1 bis 3, bei dem die in Schritt c) gebildete Maske (9) ein Muster mit einem Desorientierungswinkel per horizontaler Drehung im Verhältnis zu dem Muster aufweist, das per Abwechslung von Vertiefungen (6) und anfänglichen Erhebungen (7) gebildet ist.

5. Verfahren gemäß einem der Ansprüche 1 bis 4, umfassend Schritte vor dem Schritt a):
f) des Bildens einer Maske (4) auf der Oberfläche des Substrats (1) und
g) des Gravierens des mit der Maske (4) versehenen Substrats (1) zum Bilden der Abwechslung von Vertiefungen (6) und anfänglichen Erhebungen (7) in der Oberfläche des Substrats (1).

6. Verfahren gemäß Anspruch 5, umfassend einen Schritt vor dem Schritt f):
i) des Gravierens des Substrats (1) derart, dass eine hartgewalzte Schicht des Substrats eliminiert wird und eine schwache Oberflächenrauheit erhalten wird, die typischerweie geringer ist als 30 nm.

7. Verfahren gemäß einem der Ansprüche 1 bis 6, bei dem die in Schritt c) gebildete Maske (9) vor dem Bilden der Einkristallschicht (31) in Schritt e) eliminiert wird oder bei dem die in Schritt f) gebildete Maske (4) vor dem Bilden der Einkristallschicht (30) in Schritt a) eliminiert wird.

8. Verfahren gemäß einem der Ansprüche 1 bis 7, bei dem die Schritte b) bis e) bis zum Erhalt einer Mängeldichte in der Einkristallschicht (30, 31) erhalten wird, die geringer als oder gleich einem vorbestimmten Schwellenwert ist.

9. Verfahren gemäß einem der Ansprüche 1 bis 8, bei dem die Schritte b) bis e) zwischen einem und zwanzig Mal, bevorzugt zwischen einem und vierzehn Mal, wiederholt sind.

10. Verfahren (200) zur Herstellung eines Einkristalls, umfassend einen Schritt:
j) des Bildens eines ersten Einkristalls (22) per normalem homoepitaxialen Wachstum ausgehend von einem Einkristall (16) aus Material, das durch das Verfahren gemäß Definition durch einen der Ansprüche 1 bis 9 erhalten ist

11. Verfahren (200) zur Herstellung eines Einkristalls gemäß Anspruch 10, umfassend darüber hinaus die Schritte:
k) des Bildens eines zweiten Einkristalls (23) per normalem homoepitaxialen Wachstum ausgehend von dem ersten Einkristall (22),
l) des Wiederholens des Schritts k) unter Verwenden des zweiten, in dem vorherigen Schritt k) erhaltenen Einkristalls als ersten Einkristall für den folgenden Schritt l).

12. Verfahren (200) zur Herstellung eines Einkristalls gemäß einem der Ansprüche 10 bis 11, bei dem die Schritte j) und / oder k) mit einem normalen und lateralen homoepitaxialen Wachstum ausgehend von dem ersten Einkristall (22) realisiert sind.

13. Verfahren (200) zur Herstellung eines Einkristalls, umfassend einen Schritt:
m) des Formens eines Einkristalls (23) per homoepitaxialem Wachstum ausgehend von einem Einkristall (22) der durch das Verfahren gemäß Definition durch Anspruch 10, 11 oder 12 erhalten ist.

## Claims

1. Method (100) for forming a monocrystal of diamond material from a monocrystalline substrate (1) having a given thickness E and a surface with alternating recesses (6) and initial elevations (7), the method unfolding in the same given thickness E, without epitaxial lateral overgrowth ELOG, and comprising the steps of:
a) forming portions (11) by lateral homoepitaxial growth between the initial elevations (7) in order to carry out a layer of monocrystal (30) having a thickness less than the given thickness E of the monocrystalline substrate (1) and contained in the given thickness E, the monocrystalline substrate (1) and the layer of monocrystal (30) being formed from the same material,
b) detecting defect areas in the layer of monocrystal (30) by etching of the layer of monocrystal, which appear at least partially on the initial elevations (7),
c) forming a mask (9) on the layer (30) of monocrystal between the detected defect areas, the mask (9) having a pattern that includes openings (10) on defect areas,
d) etching in a thickness less than the given thickness E of monocrystalline substrate (1), the layer (30) of monocrystal provided with a mask (9) in such a way as to form recesses (13) in the defect areas of the layer (30) situated at the location of the openings (10), and new elevations (14) outside the defect areas of the layer (30) in the masked areas of the layer of monocrystal (30) covered by the mask (9),
e) repeating a new step a) between the new elevations (14) by lateral homoepitaxial growth from the lateral walls (15) of the new elevations (14) in a thickness less than the given thickness E of monocrystalline substrate and contained in the given thickness E, in order to form a layer of monocrystal (31),
the mask (9) having been eliminated at the end of the step (d) or at the end of the step (e).

2. Method according to claim 1, wherein at the step c), the mask (9) has a pattern that includes openings (10) located at least partially on the initial elevations (7).

3. Method according to claim 1 or 2, wherein at the step c), the mask (9) has a pattern that includes openings (10) centred on the initial elevations (7).

4. Method according to one of claims 1 to 3, wherein the mask (9) formed in the step c) has a pattern that has a disorientation angle through horizontal rotation in relation to the pattern formed by the alternating of recesses (6) and of initial elevations (7) .

5. Method according to one of claims 1 to 4, comprising steps prior to the step a) of:
f) forming a mask (4) on the surface of the substrate (1), and
g) etching the substrate (1) provided with the mask (4) in order to form the alternating recesses (6) and initial elevations (7) in the surface of the substrate (1) .

6. Method according to claim 5, comprising a step prior to the step f) of:
i) etching the surface of the substrate (1) in such a way as to eliminate a work-hardened layer of the substrate and to obtain a low surface roughness, typically less than 30 nm.

7. Method according to one of claims 1 to 6, wherein the mask (9) formed in the step c) is eliminated before forming the layer of monocrystal (31) during the step e), or wherein the mask (4) formed in the step f) is eliminated before forming the layer of monocrystal (30) during the step a).

8. Method according to one of claims 1 to 7, wherein the steps b) to e) are repeated until the obtaining of a density of defects in the layer of monocrystal (30, 31), less than or equal to a predetermined threshold.

9. Method according to one of claims 1 to 8, wherein the steps b) to e) are repeated between one and twenty times, more preferably between one and four times.

10. Method (200) for manufacturing a monocrystal, comprising a step of:
j) forming a first monocrystal (22) by normal homoepitaxial growth from a monocrystal (16) of material obtained by the method such as defined by one of claims 1 to 9.

11. Method (200) for manufacturing a monocrystal according to claim 10, further comprising steps of:
k) forming a second monocrystal (23) by normal homoepitaxial growth from the first monocrystal (22),
l) repeating the step k) by using the second monocrystal obtained at the preceding step k) as a first monocrystal for the following step l).

12. Method (200) for manufacturing a monocrystal according to one of claims 10 to 11, wherein the steps j) and/or k) are carried out with a normal and lateral homoepitaxial growth from the first monocrystal (22).

13. Method (200) for manufacturing a monocrystal comprising a step of:
m) forming a monocrystal (23) by homoepitaxial growth from a monocrystal (22) obtained by the method such as defined by claim 10, 11 or 12.
